# DEMANDE DE BREVET EUROPEEN

(11) **EP 4 142 247 A1**
(43) Date de publication de la demande: **01.03.2023**
(21) Numéro de dépôt: 22191151.4
(22) Date de dépôt: 19.08.2022
(51) Int. Cl.: H04L 45/24

(54) **PROCEDE DE TRANSMISSION ET DISPOSITIF NOEUD IMPLEMENTANT LEDIT PROCEDE**

(30) Priorité: 26.08.2021 FR 2108915
(71) Demandeur: Sagemcom Energy & Telecom SAS, 92500 Rueil-Malmaison (FR)
(72) Inventeur: BAROIS, Jérôme, 92500 RUEIL MALMAISON (FR); BACRI, Guillaume, 92500 RUEIL MALMAISON (FR)
(74) Mandataire: Cabinet Le Guen Maillet

(57) **Abrégé**

Un procédé de transmission est décrit. Ce procédé permet de transmettre des données à partir d'un premier dispositif nœud vers un second dispositif nœud appartenant à un voisinage réseau dudit premier dispositif nœud, lesdits premier et second dispositifs nœuds appartenant à un réseau d'alimentation électrique. Ces nœuds sont configurés pour transmettre lesdites données par courants porteurs en ligne et par radio-fréquences. Le procédé comprend les étapes suivantes mises en œuvre par ledit premier dispositif noeud :
- répartir (S 12) les données en deux groupes de données par une opération d'entrelacement desdites données, chaque groupe étant associé à un médium de communication parmi les courants porteurs en ligne et les radio-fréquences, et
- transmettre (S14) chaque donnée à une couche MAC du médium de communication associé au groupe auquel appartient ladite donnée.

## Description

### DOMAINE TECHNIQUE

Au moins un mode de réalisation concerne un procédé de transmission pour transmettre des données à partir d'un premier dispositif noeud vers un second dispositif noeud appartenant à un voisinage réseau du premier dispositif noeud, les premier et second dispositifs noeuds étant configurés pour transmettre les données par courants porteurs en ligne et par radio-fréquences. Au moins un mode de réalisation concerne un dispositif noeud implémentant ledit procédé de transmission.

### ETAT DE LA TECHNIQUE ANTERIEURE

Les communications par courants porteurs en ligne PLC (sigle signifiant « PowerLine Communications », en anglais) se développent, notamment dans le cadre des réseaux d'alimentation électrique de type AMM (sigle signifiant « Automated Meter Management », en anglais). Des réseaux de communication sont ainsi implémentés dans des réseaux d'alimentation électrique pour la collecte automatisée par un dispositif noeud de base (aussi appelé « concentrateur de données ») du réseau, auprès de compteurs électriques intelligents (« smart electricity meters » en anglais), de données de relevés de consommation énergétique que lesdits compteurs électriques intelligents sont respectivement en charge de surveiller.

La norme de communication G3-PLC est définie pour permettre aux différents dispositifs noeuds (notamment concentrateur de données et compteurs électriques intelligents) d'un tel réseau de communiquer entre eux. La norme est spécifiée dans la recommandation ITU-T G.9903 laquelle décrit notamment la couche physique (PHY) et la couche liaison de données (DLL, sigle de « Data Link Layer », en anglais) du modèle OSI (acronyme de « Open Systems Interconnection », en anglais). La norme G3-PLC est destinée à être exploitée dans des bandes fréquentielles allant de 10 à 490 kHz. Elle supporte plus particulièrement les bandes fréquentielles suivantes : la bande fréquentielle CENELEC A, qui va approximativement de 35 kHz à 91 kHz ; la bande fréquentielle FCC, qui va approximativement de 150 kHz à 480 kHz ; la bande fréquentielle ARIB, qui va approximativement de 150 kHz à 400 kHz ; et la bande fréquentielle CENELEC B, qui va approximativement de 98 kHz à 122 kHz. Ces différentes bandes fréquentielles présentent des caractéristiques différentes en termes de débit, de portée, et de résistance aux perturbateurs, notamment.

Dans une évolution de la norme G3-PLC définie dans une Annexe H de la recommandation ITU-T G.9903 (2017) Amendement 1 (05/2021), appelée G3-PLC Hybrid PLC & RF, un canal RF (acronyme de radio-fréquences) peut être utilisé à la place d'une desdites bandes fréquentielles PLC. Plus précisément, cette version de la norme permet l'utilisation occasionnelle d'une couche physique radio secondaire basée sur une modulation SUN FSK telle que définie dans le standard IEEE 802.15.4:2015. Ainsi, en utilisant les différents média de communication G3-PLC et RF pour transmettre des données, le réseau d'alimentation électrique maximise sa couverture et sa résilience. Un dispositif noeud réseau d'alimentation électrique capable d'émettre et de recevoir des données en utilisant les deux média (PLC et RF) est appelé noeud hybride.

Toutefois, dans G3-PLC Hybrid PLC & RF, le choix de communiquer entre deux noeuds hybrides du réseau de communication soit par courants porteurs en ligne sur une bande fréquentielle PLC soit par radio-fréquences sur un canal RF est déterminé au moment de la construction ou de la reconstruction des routes de communication. Ce choix du médium de communication utilisé entre deux noeuds hybrides du réseau est généralement fixe pendant plusieurs heures. Ainsi, les messages unicast sont transmis entre lesdits deux noeuds hybrides pendant cette durée soit sur une bande fréquentielle PLC soit sur un canal RF en fonction du choix effectué au moment de la construction ou reconstruction de route. La norme G3-PLC Hybrid PLC & RF définie dans l'Amendement 1 (05/2021) ne permet donc pas d'utiliser toute la flexibilité et la robustesse offerte par l'hybridation PLC/RF

Il est souhaitable de pallier ces différents inconvénients de l'état de la technique. Il est notamment souhaitable de proposer un procédé de transmission qui permette d'améliorer la robustesse aux erreurs d'un tel réseau de communication hybride.

### EXPOSE DE L'INVENTION

Au moins un mode de réalisation concerne un procédé de transmission pour transmettre des données à partir d'un premier dispositif noeud vers un second dispositif noeud appartenant à un voisinage réseau dudit premier dispositif noeud, lesdits premier et second dispositifs noeuds appartenant à un réseau d'alimentation électrique et étant configurés pour transmettre lesdites données par courants porteurs en ligne et par radio-fréquences. Le procédé comprend les étapes suivantes mises en oeuvre par ledit premier dispositif noeud :
- répartir les données en deux groupes de données par une opération d'entrelacement desdites données, chaque groupe étant associé à un medium de communication parmi les courants porteurs en ligne et les radio-fréquences, et
- transmettre chaque donnée à une couche MAC du médium de communication associé au groupe auquel appartient ladite donnée.

Avantageusement, la robustesse aux erreurs est améliorée par entrelacement des données qui sont réparties entre les différents média de communication.

Selon un mode de réalisation particulier, le procédé comprend en outre d'encoder les données par un encodeur Reed-Solomon. L'étape de répartir les données en deux groupes de données par une opération d'entrelacement desdites données s'applique aux données encodées.

Selon un mode de réalisation particulier, répartir les données en deux groupes de données par une opération d'entrelacement desdites données comprend :
- générer un premier train binaire de N bits, chaque valeur binaire étant associée à un médium de communication parmi les courants porteurs en ligne et les radio-fréquences, N étant le nombre de données à transmettre à la couche MAC ;
- permuter, par inversion de bits, les bits dans le premier train binaire pour obtenir un second train binaire ;
et transmettre chaque donnée à une couche MAC du médium de communication associé au groupe auquel appartient ladite donnée comprend :
- transmettre chaque donnée à la couche MAC du médium de communication associé à la valeur du bit correspondant à ladite donnée dans le second train de bits.

Selon un mode de réalisation particulier, générer un premier train binaire de N bits comprend :
a) initialiser des paramètres k, N_{RF} et N_{PLC} à 0 ;
b) Si D_{PLC}< D_{RF}, positionner un bit bₖ à une première valeur et incrémenter N_{RF} de 1, sinon positionner le bit bₖ à une seconde valeur et incrémenter N_{PLC} de 1, où D_{PLC} est un débit disponible pour le médium de communication courants porteur en ligne et D_{RF} est un débit disponible pour le médium de communication radio-fréquences ;
c) Si N_{PLC}/(N_{PLC}+N_{RF})≤D_{PLC}/(D_{PLC}+D_{RF}) positionner un bit bₖ₊₁ à ladite seconde valeur et incrémenter N_{PLC} de 1 sinon positionner le bit bₖ₊₁ à ladite première valeur et incrémenter N_{RF} de 1 ;
d) Si (k+1)<N-1, incrémenter k de 1 et reprendre à l'étape c).

Selon un mode de réalisation particulier, répartir les données en deux groupes de données par une opération d'entrelacement desdites données comprend :
- obtenir deux tables d'entrelacement, chaque table d'entrelacement étant associée à un médium de communication ;
- transmettre chaque donnée à la couche MAC du médium de communication associé à la table d'entrelacement dans laquelle se trouve ladite donnée.

Selon un mode de réalisation particulier, obtenir deux tables d'entrelacement, chaque table d'entrelacement étant associée à un médium de communication comprend :
- obtenir une première table d'entrelacement T *[m, n*] de bits représentatifs des données à transmettre, la première table d'entrelacement comprenant autant de secondes tables d'entrelacement Ti [*mᵢ*, *nᵢ*] de bits que de média de communication, chaque seconde table d'entrelacement Ti [*mᵢ*, *nᵢ*] étant attribuée à un seul desdits média de communication, des différences de dimensions entre des secondes tables d'entrelacement étant susceptibles de générer une ou plusieurs positions dites invalides comprises dans la première table d'entrelacement mais non comprises dans l'une au moins des secondes tables d'entrelacement,
- entrelacer les bits par décalages successifs des lignes *m* et des colonnes *n* de la première table T *[m, n*] d'entrelacement, les décalages successifs étant réalisés sous forme de permutations circulaires des bits respectivement par ligne et par colonne,
- déplacer tout bit détecté comme présent à une position invalide de la première table d'entrelacement vers une position d'une seconde table d'entrelacement qui est disponible après l'entrelacement des bits de la première table d'entrelacement, de sorte que chaque seconde table d'entrelacement comprenne des bits affectés à l'un desdits groupes de données.

Selon un mode de réalisation particulier, l'étape pour entrelacer les bits, et les dimensions des secondes tables d'entrelacement sont conformes à la recommandation ITU-T G.9903.

Selon un mode de réalisation particulier, dans le cas où une donnée est transmise par courants porteurs en ligne, ladite donnée est transmise sur au moins une bande fréquentielle appartenant à un ensemble de bandes fréquentielles comprenant :
- la bande fréquentielle CENELEC A;
- la bande fréquentielle CENELEC B; et
- la bande fréquentielle FCC ou la bande fréquentielle ARIB.

Selon un mode de réalisation particulier, dans le cas où une donnée est transmise par radio-fréquences, ladite donnée est transmise sur une bande fréquentielle allant de 863 MHz à 870 MHz.

Un dispositif noeud est également décrit qui appartient à un réseau d'alimentation électrique et est configuré pour transmettre des données par courants porteurs en ligne et par radio-fréquences à un autre noeud dudit réseau d'alimentation électrique appartenant à son voisinage réseau. La dispositif noeud comprend :
- des moyens pour répartir les données en deux groupes de données par une opération d'entrelacement desdites données, chaque groupe étant associé à un medium de communication parmi les courants porteurs en ligne et les radio-fréquences, et
- des moyens pour transmettre chaque donnée à une couche MAC du médium de communication associé au groupe auquel appartient ladite donnée.

Un produit programme d'ordinateur est décrit qui comprend des instructions pour mettre en oeuvre le procédé de transmission selon l'un des modes de réalisation précédents, lorsque ledit programme est exécuté par un processeur.

Un support de stockage est également décrit qui stocke un programme d'ordinateur comprenant des instructions pour mettre en oeuvre le procédé de transmission selon l'un des modes de réalisation précédents, lorsque ledit programme est exécuté par un processeur.

### BREVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
[Fig. 1] illustre schématiquement un réseau de communication maillé ;
[Fig. 2] illustre schématiquement les différentes couches d'un modèle OSI dans le cas particulier de la norme G3-PLC Hybrid PLC et RF ;
[Fig. 3] illustre schématiquement un procédé de transmission selon un mode de réalisation particulier ;
[Fig. 4] illustre schématiquement un procédé de transmission selon un mode de réalisation particulier ;
[Fig. 5] illustre en détails une étape du procédé de transmission illustré sur la Fig. 4 ;
[Fig. 6] illustre schématiquement un procédé de transmission selon un mode de réalisation particulier ;
[Fig. 7] illustre la génération d'une première table d'entrelacement de données utilisée par le procédé de transmission illustré sur la Fig.6, à partir de secondes tables d'entrelacement, selon un mode de réalisation particulier ;
[Fig. 8] illustre les positions de la première table d'entrelacement de la Fig.7 avec des références propres, selon un mode de réalisation particulier ;
[Fig. 9] illustre une opération d'entrelacement dans la première table d'entrelacement selon un mode de réalisation particulier ;
[Fig. 10] illustre un traitement (déplacement) de bits entrelacés dans la première table selon un mode de réalisation particulier ;
[Fig. 11] illustre une décomposition de la première table en secondes tables d'entrelacement pour la création de groupes de données, selon un mode de réalisation particulier ;
[Fig. 12] illustre schématiquement un exemple d'architecture matérielle d'un dispositif noeud du réseau de communication maillé selon un mode de réalisation particulier.

### EXPOSE DETAILLE DE MODES DE REALISATION

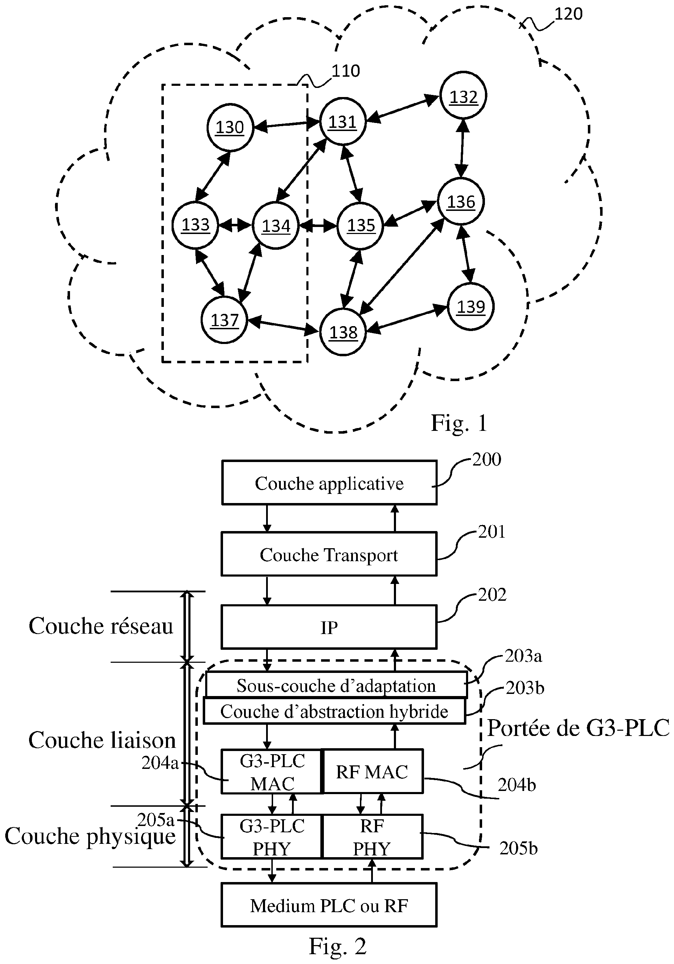

La Fig. 1 illustre schématiquement un réseau de communication maillé 120. Le réseau de communication maillé 120 est par exemple un réseau d'alimentation électrique de type AMM. Le réseau de communication maillé 120 s'appuie sur des communications par courants porteurs en ligne PLC ou par radio-fréquences RF pour permettre à un dispositif noeud de base (aussi appelé « concentrateur de données ») de collecter, auprès de compteurs électriques intelligents, des données de relevés de consommation énergétique d'installations électriques que lesdits compteurs électriques intelligents sont respectivement en charge de surveiller. Le concentrateur de données et les compteurs électriques intelligents sont ainsi des dispositifs noeuds du réseau de communication maillé 120. Le réseau de communication maillé 120 peut comporter d'autres dispositifs noeuds, par exemple installés au niveau de transformateurs électriques. Le réseau de communication 120 a donc une structure maillée, telle que représentée schématiquement sur la Fig. 1 grâce à des flèches, où des dispositifs noeuds jouent le rôle de relais pour augmenter la portée des communications dans le réseau de communication maillé 120, comme détaillé ci-après. Ainsi, un même compteur électrique intelligent dispose potentiellement de plusieurs chemins pour atteindre le concentrateur de données, et vice versa. Dans la suite du document, les termes « compteur électrique intelligent » et « compteur » sont utilisés de manière interchangeable.

La présente invention est ainsi particulièrement adaptée au contexte de la technologie G3-PLC Hybrid PLC & RF telle que définie dans la recommandation ITU-T G.9903 (2017) Amendement 1 (05/2021) et plus particulièrement dans l'Annexe H.

Le réseau de communication maillé 120 comporte ainsi une pluralité de dispositifs noeuds 130, 131, 132, 133, 134, 135, 136, 137, 138, 139. A chaque dispositif noeud du réseau de communication maillé 120 est associé un voisinage réseau. Sur la Fig. 1, le dispositif noeud 133 est associé à un voisinage réseau 110 englobant les dispositifs noeuds 130, 134 et 137. En effet, dans le réseau de communication maillé 120, un signal ou un message diffusé par un dispositif noeud (tel que le dispositif noeud 133) n'est en général pas visible en tout point dudit réseau de communication. Chaque dispositif noeud émetteur de signaux ou de messages dispose alors d'un voisinage réseau, c'est-à-dire d'un sous-ensemble dudit réseau de communication maillé 120 dans lequel tout dispositif noeud peut recevoir de manière intelligible lesdits signaux ou messages directement en provenance du dispositif noeud ayant diffusé lesdits signaux ou messages. Le voisinage réseau correspond à la portée des signaux émis, en fonction de paramètres prédéterminés de transmission (e.g. puissance, schéma de modulation et de codage, topologie réseau...) du dispositif noeud à la source desdits signaux et aussi potentiellement en fonction de caractéristiques du canal de communication (atténuation, bruit, impédance...).

Le réseau de communication maillé 120 s'appuie sur un protocole de routage de type réactif, tel que le protocole LOADng (« Lightweight On-demand Ad hoc Distance-vector Routing Protocol - Next Génération » en anglais). Contrairement aux protocoles de routage de type proactif qui s'appuient sur une connaissance globale de topologie réseau, les protocoles de routage de type réactif s'appuient sur des découvertes de routes à la demande, chaque dispositif noeud du réseau ayant alors besoin uniquement d'avoir connaissance de son propre voisinage réseau pour router des données dans le réseau de communication maillé 120.

Pour découvrir une route appropriée dans le réseau de communication maillé 120 depuis un dispositif noeud source (par exemple le dispositif noeud 133) jusqu'à un dispositif noeud destination (par exemple le dispositif noeud 132), il est connu que le dispositif noeud source diffuse (« broadcast » en anglais) une requête de découverte de route, appelée RREQ (« Route REQuest » en anglais). Dans le cas G3-PLC Hybrid PLC & RF, la requête RREQ est diffusée sur les deux média PLC et RF. Cette requête de découverte de route est reçue par chaque dispositif noeud dans le voisinage réseau dudit dispositif noeud source. Chaque dispositif noeud dans le voisinage réseau dudit dispositif noeud source relaie, par diffusion, ladite requête si ledit dispositif noeud en question n'est pas le dispositif noeud destination. Par diffusion de proche en proche, plusieurs requêtes de découverte de route sont typiquement reçues par le dispositif noeud destination, chacune de ces requêtes ayant suivi un chemin différent dans le réseau de communication maillé 120.

Chaque dispositif noeud qui est à l'origine d'un message, comme par exemple une requête de découverte de route, y inclut un identifiant qui lui est propre, ainsi qu'un numéro de séquence, tel que défini dans le protocole LOADng. Ce numéro de séquence est une valeur de compteur propre à chaque dispositif noeud du réseau de communication maillé 120. A chaque fois qu'un dispositif noeud génère un nouveau message, ledit dispositif noeud incrémente son compteur et inclut dans le message en question la valeur dudit compteur. Ainsi, lorsqu'un dispositif noeud reçoit un message, ledit dispositif noeud analyse l'identifiant du dispositif noeud à l'origine du message et le numéro de séquence inclus dans le message, et peut déterminer si le message reçu est effectivement un nouveau message ou une nouvelle copie d'un message déjà reçu.

Chaque dispositif noeud peut toutefois décider de ne pas relayer une requête de découverte de route, lorsqu'un ou plusieurs critères ne sont pas remplis. Notamment, avant de décider de relayer ladite requête, le dispositif noeud en question vérifie typiquement si ladite requête comporte une information représentative d'un coût de route, depuis le dispositif noeud source jusqu'au dispositif noeud en question, qui est meilleur que le coût de route représenté par une information contenue dans une autre requête de découverte de route précédemment reçue par le dispositif noeud en question. En d'autres termes, le dispositif noeud en question relaie, par diffusion, ladite requête si ladite requête concerne un chemin qui a suivi, depuis le dispositif noeud source jusqu'au dispositif noeud en question, un trajet de plus faible coût que toute autre requête précédemment reçue par le dispositif noeud en question (donc pour la même découverte de route).

Le coût d'une route peut s'appuyer sur une ou plusieurs métriques. Par exemple, le coût de route est un nombre de sauts (« hops » en anglais) subis par la requête en question depuis le dispositif noeud source. Selon un autre exemple, le coût de route est le résultat d'un calcul qui dépend de la bande passante des liens franchis, par la requête en question depuis le dispositif noeud source et/ou de la qualité des liens de communication. Selon encore un autre exemple, le coût de route est proportionnel à la latence subie par la requête en question depuis le dispositif noeud source. D'autres métriques peuvent être utilisées pour établir un coût de route, c'est-à-dire un coût de transit, depuis le dispositif noeud source jusqu'au dispositif noeud destination. Selon encore un autre exemple, le coût de route dépend également du média, i.e. RF ou PLC, utilisé pour transmettre les données entre deux dispositif noeuds successifs.

Lorsqu'un dispositif noeud décide de relayer, par diffusion, une requête de découverte de route, le dispositif noeud en question met à jour l'information de coût de route contenue dans ladite requête, de manière à prendre en compte que ladite requête est passée par le dispositif noeud en question. Ainsi, selon un tel principe, plusieurs requêtes de découverte de route parviennent typiquement au dispositif noeud destination, chacune comportant une information de coût de route que ladite requête a suivie pour être propagée depuis le dispositif noeud source jusqu'au dispositif noeud destination. Le trajet emprunté par ladite requête de découverte de route associée au meilleur coût de route est ensuite sélectionné pour permettre au dispositif noeud source de transmettre des données au dispositif noeud destination. Pour activer la route en question le dispositif noeud destination transmet une réponse de découverte de route, appelée RREP (« Route REPly » en anglais). Cette réponse de découverte de route est transmise de proche en proche en suivant le chemin inverse de la requête de découverte de route qui était associée au meilleur coût de route. Chaque dispositif noeud recevant la réponse de découverte de route met à jour une table de routage interne, au niveau de la couche liaison de données DLL, afin d'y indiquer que tout message ultérieur transmis en mode point-à-point (« unicast » en anglais) depuis le dispositif noeud source en question vers le dispositif noeud destination en question doit être transmis ou relayé vers tel ou tel dispositif noeud de son voisinage réseau. Au sein de la couche liaison, les tables de routage sont préférentiellement implémentées dans une sous-couche d'adaptation en charge de la mise en oeuvre du protocole de routage dans le réseau de communication. Par exemple, cette sous-couche d'adaptation est conforme au protocole 6LoWPAN (pour « IPv6 over Low power Wireless Personal Area Networks » en anglais), qui a été initialement développé pour supporter IPv6 dans le cadre de la norme IEEE 802.15.4. A noter que le protocole 6LoWPAN s'appuie lui-même sur le protocole de routage de type réactif LOADng susmentionné. Une couche d'abstraction hybride (« Hybrid abstraction layer » en anglais) fournit des services appropriés à la sous-couche d'adaptation en vue d'envoyer/recevoir des données vers/de la sous-couche MAC adéquate (acronyme anglais de « Medium Access Control » en anglais), i.e. RF ou PLC.

Grâce aux tables de routage ainsi configurées, des communications point-à-point (« unicast » en anglais) peuvent être effectuées par toute paire de dispositifs noeuds du réseau de communication maillé 120. Des dispositifs noeuds intermédiaires servent donc de relais lorsque les dispositifs noeuds de ladite paire ne sont pas dans le voisinage réseau l'un de l'autre, les communications s'opèrent ainsi de proche en proche, chaque dispositif noeud s'appuyant sur un de ses propres voisins pour faire suivre des messages jusqu'à leurs destinataires respectifs.

Pour communiquer entre dispositifs noeuds voisins (c'est-à-dire des dispositifs noeuds qui sont dans le voisinage réseau l'un de l'autre), les messages sont transmis sous forme de trames modulées. Lorsqu'une trame modulée est spécifiquement adressée à un dispositif noeud voisin et qu'elle est correctement démodulée par celui-ci, ledit dispositif noeud voisin retransmet un acquittement ACK au dispositif noeud qui lui a adressé ladite trame modulée sur la bande fréquentielle ou le canal RF sur lequel la trame modulée a été envoyée. Plusieurs bandes fréquentielles et au moins un canal RF sont définis pour supporter la transmission de ces trames modulées, un schéma de modulation adapté étant associé à chacune de ces bandes fréquentielles et au canal RF. Chaque trame transmise sous forme de signaux modulés débute par un préambule prédéfini en fonction du schéma de modulation selon lequel lesdits signaux ont été modulés. Le préambule est adapté pour permettre de se synchroniser en réception sur ladite trame, c'est-à-dire de pouvoir déterminer un instant effectif de début de trame. Pour ce faire, le préambule comporte typiquement une pluralité de copies successives d'un même symbole. Le contenu effectif et la durée du préambule sont ainsi prédéfinis et dépendent du schéma de modulation utilisé. Les préambules de plusieurs trames sont identiques lorsque le même schéma de modulation est appliqué, et diffèrent sinon. Dans la suite du document, pour alléger le texte, le terme « bande fréquentielle » est utilisé indifféremment pour désigner une bande fréquentielle PLC ou un canal RF.

Les schémas de modulation applicables (et des schémas de démodulation correspondants) sont préférentiellement des schémas de modulation (respectivement schémas de démodulation) multi-porteuse de type OFDM (« Orthogonal Frequency Division Multiplex » en anglais) en PLC ou SUN-FSK (acronyme anglais de « Smart Utility Network - Frequency Shift Keying ») en RF.

En termes de bandes fréquentielles utilisables dans le cadre de la mise en oeuvre du réseau de communication maillé 120, on peut citer : la bande fréquentielle CENELEC A, qui va approximativement de 35 kHz à 91 kHz ; la bande fréquentielle FCC, qui va approximativement de 150 kHz à 480 kHz ; la bande fréquentielle ARIB, qui va approximativement de 150 kHz à 400 kHz ; la bande fréquentielle CENELEC B, qui va approximativement de 98 kHz à 122 kHz et la bande fréquentielle pour le canal RF qui va approximativement de 863 MHz à 870 MHz. Il est alors possible d'utiliser : un premier schéma de modulation à trente-six porteuses dans la bande fréquentielle CENELEC A ; un second schéma de modulation à soixante-douze porteuses dans la bande fréquentielle FCC ; un troisième schéma de modulation à cinquante-quatre porteuses dans la bande fréquentielle ARIB ; un quatrième schéma de modulation à seize porteuses dans la bande fréquentielle CENELEC B et un cinquième schéma de modulation de type SUN-FSK pour le canal RF de G3-PLC Hybrid PLC & RF. La modulation SUN-FSK est définie dans la section 20 du document IEEE 802.15.4 :2015.

La Fig. 2 illustre schématiquement les différentes couches d'un modèle OSI dans le cas particulier de la norme G3-PLC Hybrid PLC & RF telle que définie dans l'annexe H de la recommandation ITU-T G.9903 (2017) Amendement 1 (05/2021).

Un message à transmettre provenant d'une couche applicative 200 est transmis à une couche transport 201. La couche transport 201 regroupe l'ensemble des protocoles chargés de la gestion des erreurs et du contrôle des flux réseaux. Les deux principaux protocoles utilisés sont les protocoles TCP et UDP. La couche transport 201 crée des paquets en ajoutant des entêtes aux données en provenance de la couche applicative 200. Les paquets sont ensuite transmis à une couche IP 202, e.g. IPv6. La couche IP 202 encapsule les paquets en provenance de la couche transport 201 en ajoutant notamment un entête IP, e.g. IPv6. Un paquet IPv6 peut faire jusqu'à 1400 octets. Dans le cas où le paquet est de taille supérieure à une valeur de seuil, ce paquet est fragmenté en au moins deux fragments afin de l'adapter aux contraintes d'une sous-couche MAC 204a ou 204b, notamment à la taille des trames MAC.

A cet effet, la norme G3-PLC Hybrid PLC & RF incorpore le protocole 6LoWPAN lequel permet d'adapter des paquets de données IPv6 aux contraintes des sous-couches MAC 204a ou 204b, notamment en les fragmentant. En effet, les trames MAC utilisées sont de tailles bien inférieures (400 octets maximum disponibles par paquet pour la partie IP) aux paquets IPv6 de 1 400 octets.

Une sous-couche adaptation 203a incorporant le protocole 6LoWPAN et située entre la couche réseau IP 202 et la sous-couche MAC 204a ou 204b du modèle OSI reçoit de la couche réseau IP 202 des paquets IPv6 de 1 280 octets et le cas échéant les fragmente. Bien entendu dans le cas d'un paquet IP suffisamment petit pour être contenu dans une seule trame MAC G3-PLC ou MAC RF aucune fragmentation n'est effectuée.

Une couche d'abstraction hybride 203b transfère ensuite le fragment ou le paquet IP en cas d'absence de fragmentation à la sous-couche MAC appropriée 204a ou 204b en fonction du médium choisi pour sa transmission. Dans la suite le terme fragment est utilisé pour désigner à la fois un fragment obtenu à partir d'un paquet IP fragmenté ou bien le paquet IP lui-même en cas d'absence de fragmentation.

La transmission d'un fragment sur le médium PLC, i.e. sur la ligne de courant, comprend classiquement différentes étapes notamment une segmentation des fragments afin de les adapter à une couche physique G3-PLC PHY 205a et une modulation OFDM du signal. La segmentation consiste à partitionner une trame MAC en PSDUs (acronyme anglais de « PHY Service Data Unit »). Tous les PSDU issus d'un même fragment sont modulés en utilisant un même schéma de modulation.

La transmission d'un fragment par radio-fréquences sur le canal RF comprend différentes étapes notamment une segmentation des fragments afin de les adapter à une couche physique RF PHY 205b et une modulation SUN-FSK du signal. Comme dans le cas PLC, la segmentation consiste à partitionner une trame MAC en PSDUs (acronyme anglais de « PHY Service Data Unit »). Tous les PSDU issus d'un même fragment sont modulés en utilisant un même schéma de modulation. La spécification de la couche physique RF PHY est donnée dans les sections 10, 11 et 20 de la norme IEEE 802.15.4-2015 telle que modifiée par le document IEEE 802.15.4v:2017 et complété par la Table H-5-1 de la recommandation ITU-T G.9903 (2017) Amendement 1 (05/2021).

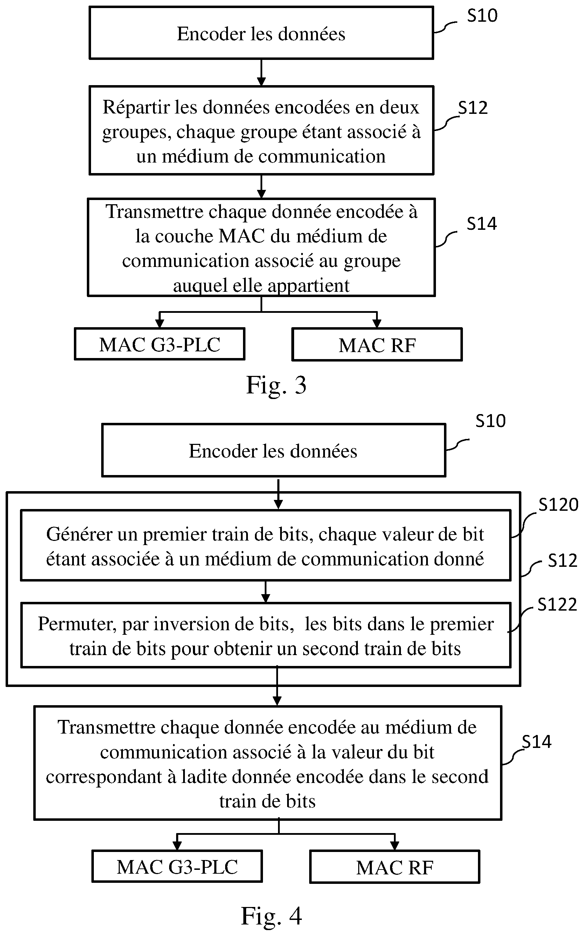

Afin d'utiliser toute la flexibilité offerte par l'hybridation PLC/RF, les procédés de transmission décrits en référence aux Figs. 3 à 11 sont mis en oeuvre pour répartir les données fournies par la sous-couche d'adaptation 203a entre les deux couches MAC RF et MAC PLC de manière optimale afin notamment d'assurer une plus grande robustesse aux erreurs. Plus précisément, les procédés décrits sont mis en oeuvre au niveau de la couche d'abstraction hybride 203b.

La Fig. 3 illustre schématiquement un procédé de transmission de données selon un mode de réalisation particulier. Les données proviennent par exemple de la couche IP.

Lors d'une étape S10 optionnelle, les données issues de la couche IP possiblement fragmentées selon le protocole 6LowPAN sont encodées, e.g. par un encodeur convolutionnel tel qu'un encodeur de type Reed-Solomon. Dans un mode particulier de réalisation, l'encodeur Reed-Solomon est paramétré comme suit : N=255, K=247 et T=4, où N est un nombre de symboles transmis, K est un nombre de symboles d'information, appelé charge utile et T est un nombre de symboles erronés corrigeables. Les codes Reed-Solomon sont des codes par bloc. En effet ils prennent en entrée un bloc de données de taille fixée K, chaque donnée étant un symbole de m bits. Par exemple, m=1, 2, 3, 4, 8 ou 16. On ajoute à ce bloc 2T symboles de contrôle, formant ainsi un bloc de sortie de taille fixée égale à N.

Lors d'une étape S12, les N données encodées sont réparties en deux groupes G_{RF} et G_{PLC} par une opération d'entrelacement, chaque groupe étant associé à un médium de communication particulier parmi les courants porteurs en ligne et les radio-fréquences. Lors d'une étape S14, chaque donnée encodée est transmise à la couche MAC du médium de communication associé au groupe auquel elle appartient. Dit autrement, les données encodées qui appartiennent au groupe G_{RF} sont transmises à la couche MAC RF et les données encodées qui appartiennent à l'autre groupe sont transmises à la couche MAC PLC.

Le dispositif noeud recevant les données transmises par PLC et RF opère de façon inverse. En d'autres termes, le dispositif noeud récepteur désentrelace les données de façon inverse à ce qui est réalisé par le dispositif noeud émetteur lors de l'étape S12. Les données ainsi désentrelacées sont ensuite décodées en utilisant un décodeur effectuant l'opération inverse de celle effectuée à l'étape S10. Dans un mode de réalisation particulier, un décodeur Reed-Solomon est utilisé.

La Fig. 4 illustre schématiquement un procédé de transmission de données selon un mode de réalisation particulier. Ce procédé comprend l'étape S10 identique à celle du procédé décrit en référence à la Fig. 3.

Lors d'une étape S120, un premier train de bits est généré qui comprend N bits bₖ avec k∈[0 ;N-1], i.e. autant de bits que de symboles Sₖ contenus dans un bloc de sortie de l'étape d'encodage S10.

Lors d'une étape S122, les bits du premier train de bits sont permutés par exemple en utilisant un procédé de permutation par inversion de bits. Un tel procédé de permutation permet de conserver le même nombre de 0 et de 1 que dans le premier train de bits et est réversible. Le train de bits après permutation est appelé second train de bits.

Dans un exemple de réalisation, pour N=255, la fonction F suivante est utilisée : F= [0, 128, 64, 192, 32, 160, 96, 224, 16, 144, 80, 208, 48, 176, 112, 240, 8, 136, 72, 200, 40, 168, 104, 232, 24, 152, 88, 216, 56, 184, 120, 248, 4, 132, 68, 196, 36, 164, 100, 228, 20, 148, 84, 212, 52, 180, 116, 244, 12, 140, 76, 204, 44, 172, 108, 236, 28, 156, 92, 220, 60, 188, 124, 252, 2, 130, 66, 194, 34, 162, 98, 226, 18, 146, 82, 210, 50, 178, 114, 242, 10, 138, 74, 202, 42, 170, 106, 234, 26, 154, 90, 218, 58, 186, 122, 250, 6, 134, 70, 198, 38, 166, 102, 230, 22, 150, 86, 214, 54, 182, 118, 246, 14, 142, 78, 206, 46, 174, 110, 238, 30, 158, 94, 222, 62, 190, 126, 254, 1, 129, 65, 193, 33, 161, 97, 225, 17, 145, 81, 209, 49, 177, 113, 241, 9, 137, 73, 201, 41, 169, 105, 233, 25, 153, 89, 217, 57, 185, 121, 249, 5, 133, 69, 197, 37, 165, 101, 229, 21, 149, 85, 213, 53, 181, 117, 245, 13, 141, 77, 205, 45, 173, 109, 237, 29, 157, 93, 221, 61, 189, 125, 253, 3, 131, 67, 195, 35, 163, 99, 227, 19, 147, 83, 211, 51, 179, 115, 243, 11, 139, 75, 203, 43, 171, 107, 235, 27, 155, 91, 219, 59, 187, 123, 251, 7, 135, 71, 199, 39, 167, 103, 231, 23, 151, 87, 215, 55, 183, 119, 247, 15, 143, 79, 207, 47, 175, 111, 239, 31, 159, 95, 223, 63, 191, 127, 255]

Pour tout k∈[0 ;N-1], Bₖ=b_{F(k)} où Bₖ est un bit du second train de bit. Par exemple, la valeur du bit B₅ est égale à la valeur du bit b₁₆₀. Si on applique la fonction F deux fois de suite, on retrouve le train de bits de départ.

Ainsi, le second train de bits définit deux groupes de données G_{RF} et G_{PLC}. Le groupe G_{RF} comprend, par exemple, l'ensemble des données correspondant à un bit à 1 dans le second train de bits et le groupe G_{PLC} comprend l'ensemble des données correspondant à un bit à 0 dans le second train de bits, ou vice-versa.

Lors de l'étape S14, les données encodées qui appartiennent au groupe G_{RF} sont transmises à la couche MAC RF et les données encodées qui appartiennent au groupe G_{PLC} sont transmises à la couche MAC PLC. Dit autrement, chaque donnée encodée est transmise au médium de communication associé à la valeur du bit correspondant à ladite donnée encodée dans le second train de bits.

Ainsi, pour tout k∈[0 ;N-1], si Bₖ est égal à 0, alors le symbole Sₖ en sortie de l'étape d'encodage est transmis à la couche MAC G3-PLC et si Bₖ est égal à 1, alors le symbole Sₖ en sortie de l'étape d'encodage est transmis à la couche MAC RF.

Le procédé de transmission décrit permet donc de répartir les données entre les deux média de communication et ce de manière réversible. Dans le mode de réalisation décrit ci-dessus, le bit à 1 est associé au médium de communication RF et le bit à 0 est associé au médium de communication PLC. Bien entendu, il s'agit d'une convention de départ et un choix différent peut être fait, i.e. associer au médium de communication RF un bit à 0 et associer au médium de communication PLC un bit à 1.

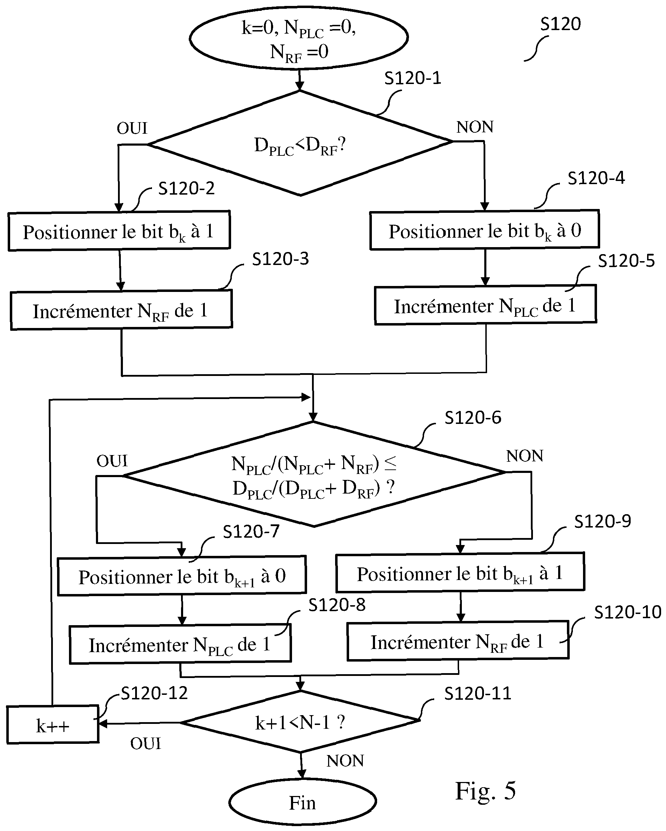

La Fig. 5 illustre en détails l'étape S120 du procédé de transmission de données de la Fig. 4 selon un mode de réalisation particulier.

Des paramètres k, N_{PLC} et N_{RF} sont initialisés à 0. k est un indice qui identifie un bit bₖ dans le premier train de bits. N_{PLC} (respectivement N_{RF}) représente le nombre de bits transmis sur le médium PLC (respectivement RF).

Lors d'une étape S120-1, un débit D_{PLC} est comparé à un débit D_{RF}. D_{PLC} est un débit de données disponibles pour le médium de communication courants porteurs en ligne et D_{RF} est un débit de données disponibles pour le médium de communication radio-fréquences. Chaque débit de données disponible D_{PLC} et D_{RF} est connu.

Pour les courants porteurs en ligne, D_{PLC} est défini dans le document ITU-T G.9903 (2017) Amendement 1 (05/2021), plus précisément dans la section 7.3.1, et dépend de la bande fréquentielle, du nombre de porteuses et de l'encodage actuellement sélectionnés.

Pour les radio-fréquences, D_{RF} est défini dans les spécifications IEEE 802.15-4 et IEEE 802.15-4v_2017, plus précisément dans la section 20.3, et dépend du mode d'opération actuellement configuré. Le mode d'opération 1 ou 2 de SUN FSK traduit des écartements fréquentiels différents entre les canaux.

Si D_{PLC}<D_{RF}, alors le bit bₖ est mis à 1 (S120-2) et N_{PLC} est incrémenté de 1 (S120-3). Si D_{PLC}≥D_{RF}, alors le bit bₖ est mis à 0 (S 120-4) et N_{RF} est incrémenté de 1 (S 120-5).

Lors d'une étape S120-6, N_{PLC}/(N_{PLC+} N_{RF}) est comparé à D_{PLC}/(D_{PLC+} D_{RF}). Si N_{PLC}/(N_{PLC+} N_{RF}) ≤D_{PLC}/(D_{PLC+} D_{RF}), le bit suivant bₖ₊₁ est mis à 0 (S 120-7) et N_{PLC} est incrémenté de 1 (S120-8).

Si N_{PLC}/(N_{PLC+} N_{RF}) >D_{PLC}/(D_{PLC+} D_{RF}), le bit suivant bₖ₊₁ est mis à 1 (S 120-9) et N_{RF} est incrémenté de 1 (S120-10).

Lors d'une étape S120-11, (k+1) est comparé à (N-1). Si (k+1) < (N-1), alors k est incrémenté de 1 et le procédé reprend à l'étape S120-6, sinon l'étape S120 prend fin puisque tous les bits bₖ avec k∈[0 ;N-1] du premier train de bits sont déterminés et donc le premier train de bits est généré. Dans le mode de réalisation décrit ci-dessus le bit à 1 est associé au médium de communication RF et le bit à 0 est associé au médium de communication PLC. Bien entendu, il s'agit d'une convention de départ et un choix différent peut être fait, i.e. associer au médium de communication RF un bit à 0 et associer au médium de communication PLC un bit à 1. Ainsi, dans l'exemple de la Fig. 5, les 0 peuvent être remplacés par des 1 et les 1 par des 0.

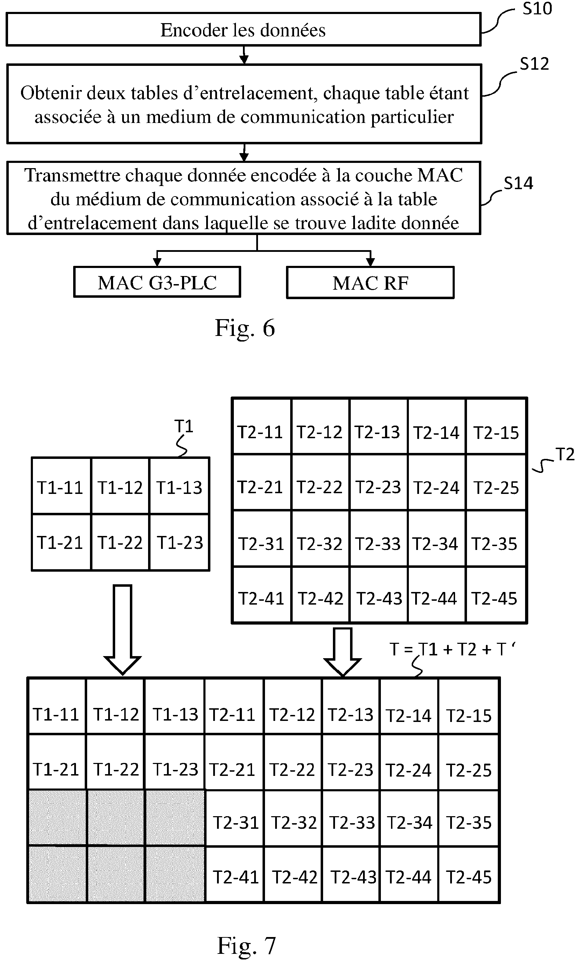

La Fig. 6 illustre schématiquement un procédé de transmission de données selon un mode de réalisation particulier. Ce procédé comprend l'étape S10 identique à celle du procédé décrit en référence à la Fig. 3.

Lors de l'étape S12, deux tables d'entrelacement sont obtenues, une table étant associée au médium de communication PLC et l'autre table étant associée au médium de communication RF.

Lors de l'étape S14, les données encodées sont transmises à la couche MAC RF et à la couche MAC PLC en fonction des tables d'entrelacement obtenues. Plus précisément, chaque donnée encodée est transmise à la couche MAC du médium de communication associé à la table d'entrelacement dans laquelle se trouve ladite donnée.

Le procédé de transmission décrit permet donc de répartir les données entre les deux média de communication et ce de manière réversible.

Les Figs 7 à 11 illustrent un procédé d'obtention des tables d'entrelacement utilisées à l'étape S14.

La Fig. 7 illustre une première table T d'entrelacement, obtenue à partir de la concaténation de secondes tables d'entrelacement T1 et T2. Les tables d'entrelacement T1 et T2 présentent des dimensions respectives (nombre de lignes *mᵢ* et de colonnes *n*ᵢ) définies à partir du type de médium de communication utilisé. Selon un mode de réalisation particulier, un premier médium utilise les courants porteurs en ligne et un second médium utilise les radio-fréquences. Ainsi, la table d'entrelacement T1 est associée au médium de communication RF. Dans l'exemple de la Fig. 7, ses dimensions sont définies par 2 lignes et 3 colonnes. Le nombre de colonnes correspond à un nombre de canaux et le nombre de lignes correspond à un nombre de bits à entrelacer. Le nombre de canaux est par exemple défini dans IEEE 802.15.4v_2017 en fonction du mode d'opération, e.g. en mode d'opération 1, il y a 69 canaux et 35 canaux en mode d'opération 2. De manière à simplifier la description, 3 canaux sont considérés sur la Fig.7 et donc 3 colonnes pour la table d'entrelacement T1. De façon similaire, la table d'entrelacement T2 est associée au médium de communication PLC. Dans l'exemple de la Fig. 7, ses dimensions sont définies par 4 lignes et 5 colonnes. La table d'entrelacement T2 est définie de la même manière que la table d'entrelacement utilisée au niveau de la couche PHY dans les sections 7.10.1 et 7.10.2 de la norme G3-PLC. Ainsi, les dimensions de la table d'entrelacement T2 sont définies de sorte que le nombre de colonnes est égal au nombre de sous-porteuses utilisées dans la bande fréquentielle utilisée pour la transmission des données et le nombre de lignes dépend du nombre de bits à entrelacer. La table d'entrelacement T2 de la Fig. 7 correspond au médium PLC configuré en bande fréquentielle FCC avec 5 sous-porteuses et une modulation QPSK.

La première table d'entrelacement T est obtenue par une concaténation des secondes tables d'entrelacement T1 et T2. Des indices T1-11 à T1-13 symbolisent les différentes positions de la première ligne de la table d'entrelacement T1, et des indices T1-21 à T1-23 symbolisent les différentes positions de la deuxième ligne de la table d'entrelacement T1. De la même façon, des indices T2-11 à T2-15 symbolisent les différentes positions de la première ligne de la table d'entrelacement T2, des indices T2-21 à T2-25 symbolisent les différentes positions de la deuxième ligne de la table d'entrelacement T2, des indices T2-31 à T2-35 symbolisent les différentes positions de la troisième ligne de la table d'entrelacement T2 et des indices T2-41 à T2-45 symbolisent les différentes positions de la quatrième ligne de la seconde table d'entrelacement T2. Ainsi, plus généralement, un indice Ti [*mᵢ*,*nᵢ*] symbolise dans la présente description une position à la m ^{ième} ligne et la *n* ^{ième} colonne d'une table Ti. Les indices précédemment cités sont apposés dans les différentes positions de la table d'entrelacement T obtenue par concaténation des tables d'entrelacement T1 et T2, sur la Fig 7 pour mieux illustrer le mode de concaténation utilisé. Selon un mode de réalisation, les tables d'entrelacement T1 et T2 sont concaténées pour définir la première table T en faisant concorder la première ligne de la table d'entrelacement T1 avec la première ligne de la table d'entrelacement T2, puis la deuxième ligne de la table d'entrelacement T1 avec la deuxième ligne de la table d'entrelacement T2. Ainsi, la définition de la première table d'entrelacement T correspond à l'addition de la table d'entrelacement T1 et de la table d'entrelacement T2 auxquelles s'ajoutent une table d'entrelacement T' (représentée en grisée sur le Fig. 7) de sorte que la première table d'entrelacement T présente un même nombre de positions dans chacune de ses colonnes et dans chacune de ses lignes. Afin de simplifier les opérations d'entrelacement selon le mode de réalisation décrit, les positions comprises dans la table d'entrelacement T', i.e. comprises dans la première table d'entrelacement T mais non comprises dans l'une au moins des tables d'entrelacement T1 et T2, sont dites « invalides ». En effet, après un entrelacement opéré dans la première table d'entrelacement T, des données pourraient être déplacées dans l'une de ces positions.

Une opération d'entrelacement dans une table d'entrelacement consiste usuellement à décaler un certain nombre de fois le contenu de chacune des lignes et des colonnes par permutations circulaires des bits contenus dans les positions de la table.

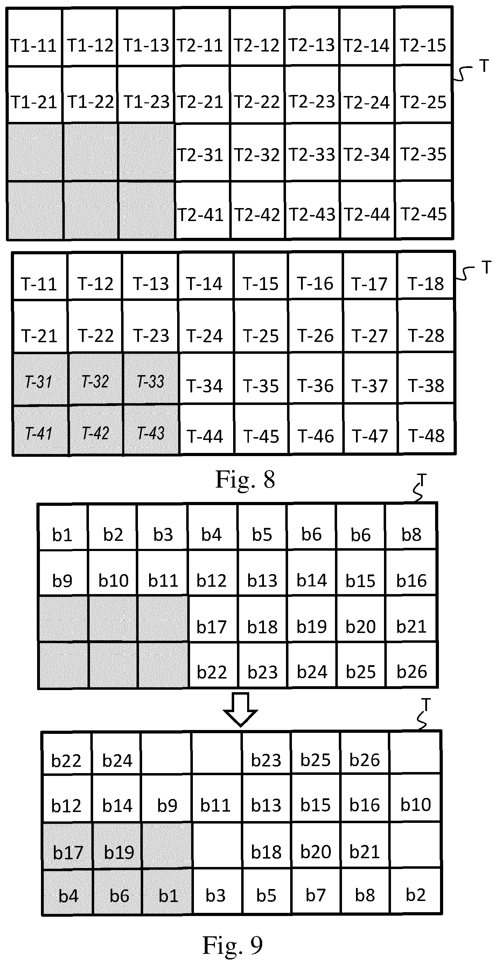

La Fig. 8 illustre la correspondance des indices propres à une identification des positions dans la première table d'entrelacement T avec les indices propres à une identification des positions dans chacune des tables d'entrelacement T1 et T2, ou des positions invalides de la table d'entrelacement T'. Ainsi, par exemple, la position T1-11 de la table d'entrelacement T1 correspond à la position T-11 de la première table d'entrelacement T, et la position T2-32 de la table d'entrelacement T2 correspond à la position T-35 de la première table d'entrelacement T, ce qui permet de bien comprendre comment sont respectivement identifiées les positions selon qu'elles se réfèrent à la première table d'entrelacement T, obtenue par concaténation, ou à l'une des tables d'entrelacement T1 et T2 définies en fonction d'un type de médium de communication et des paramètres liés à ces médium de communication, e.g. nombre de canaux en RF et type de modulation, nombre de sous-porteuses et bandes fréquentielles en PLC).

Les positions T-31, T-32, T-33, T-41, T-42 et T-43 sont les positions invalides de la première table d'entrelacement T.

La Fig. 9 illustre l'opération d'entrelacement réalisée dans la première table d'entrelacement T par le procédé de transmission selon l'invention. La partie supérieure de la figure représente la première table d'entrelacement T définie préalablement à l'entrelacement de sorte que chacune des positions de la table d'entrelacement T qui n'est pas invalide comprend un bit en provenance du flux des bits à entrelacer (fourni, par exemple en sortie d'un encodeur convolutionnel, e.g. de type Reed-Solomon). Les bits b1 à b26 du flux des bits sont « chargés » de gauche à droite et de haut en bas dans la première table d'entrelacement T de sorte que les positions invalides soient ignorées. Le bit b1 est chargé dans la position T-11, b2 est chargé dans la position T-12, ... b13 dans la position T-25, ... et b26 dans la position T-48. Les positions invalides T-31, T-32, T-33, T-41, T-42 et T-43 de la première table d'entrelacement T sont ignorées pour le chargement des bits b1 à b26. On obtient ainsi la première table d'entrelacement T comprenant les tables d'entrelacement T1 et T2, prêtes pour une opération d'entrelacement visant à répartir les données chargées (bits) en plusieurs groupes de données attribués chacun à un médium de communication. L'opération d'entrelacement en elle-même n'est pas décrite sur la Fig. 9 mais est symbolisée par une flèche menant de la représentation de l'état de la première table d'entrelacement T préalablement à l'entrelacement, vers la représentation de l'état de la première table d'entrelacement T suite à l'entrelacement. Ainsi la partie inférieure de la Fig. 9 représente la première table d'entrelacement T après l'opération globale d'entrelacement. Le bit b22 occupe la position occupée par le bit b1 avant l'entrelacement, le bit b24 occupe la position occupée par le bit b2 avant l'entrelacement, le bit b23 occupe la position occupée par le bit b5 avant l'entrelacement, ..., et ainsi de suite. L'entrelacement ayant été réalisé dans des lignes et des colonnes entières de la première table d'entrelacement T, il en résulte que des positions invalides peuvent comprendre des bits suite à l'entrelacement. Selon le mode de réalisation, ces bits sont alors déplacés vers des positions valides de la première table d'entrelacement T.

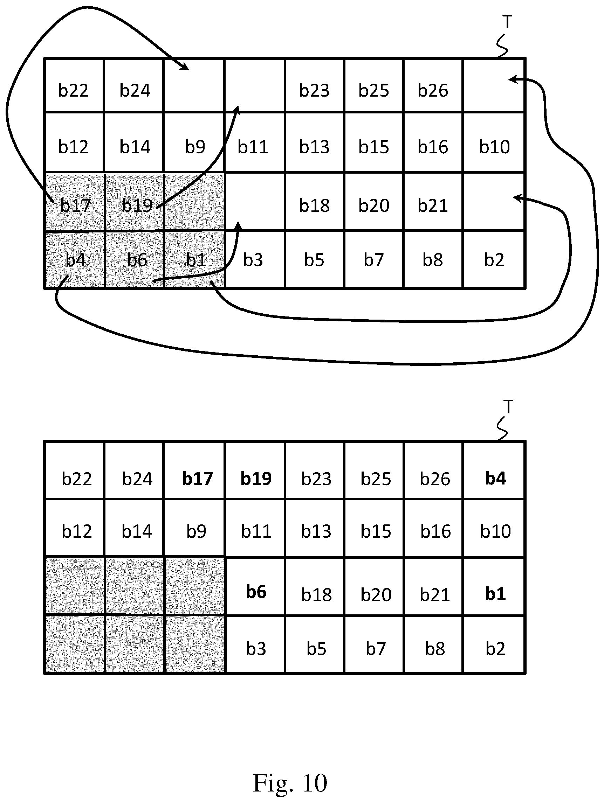

La Fig. 10 illustre des déplacements des bits de positions invalides de la première table d'entrelacement T vers des positions valides, c'est-à-dire des positions comprises dans l'une des tables d'entrelacement T1 et T2. Ces déplacements des bits sont symbolisés par des flèches.

Selon un mode de réalisation, ces déplacement sont réalisés en parcourant les positions invalides de la table T' de haut en bas et de gauche à droite. Dès qu'une position invalide comprend un bit bi où i est un indice identifiant le bit (sur la Fig. 10 i est un entier appartenant à [1 ; 26], celui-ci est déplacé vers la première position valide disponible rencontrée en parcourant la première table d'entrelacement T de haut en bas et de gauche à droite. La partie supérieure de la Fig. 10 illustre les déplacements des bits ainsi opérés, et la partie inférieure de la Fig. 10 illustre les positions respectives des bits au terme de ce traitement (déplacements).

Astucieusement, chacune des tables d'entrelacement T1 et T2 comprend un groupe des bits des données réparties en groupes correspondant chacun à un médium de communication parmi PLC et RF. En d'autres termes et selon l'exemple décrit, les bits compris dans la table d'entrelacement T1 sont transmis à la sous-couche MAC RF en vue d'une transmission en RF, et les bits compris dans la table d'entrelacement T2 sont transmis à la sous-couche MAC PLC en vue d'une transmission en PLC.

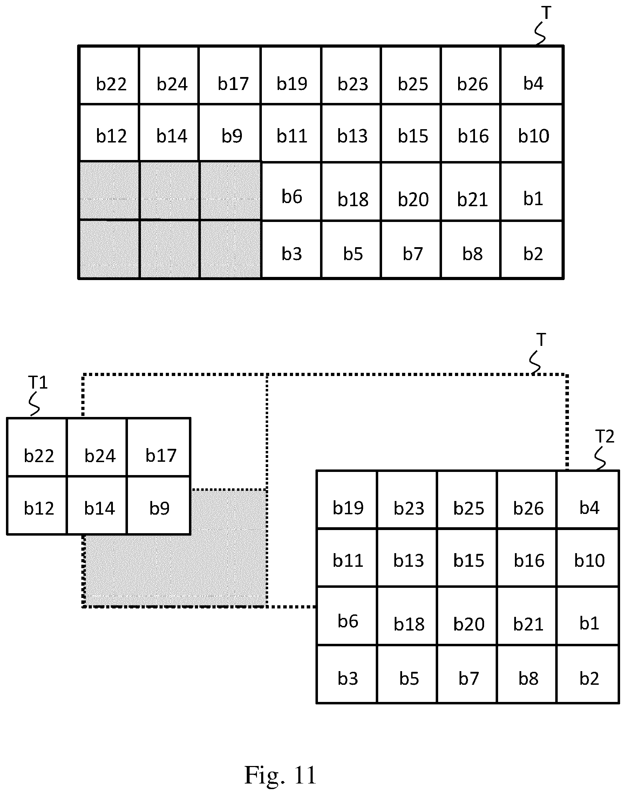

La Fig.11 illustre la répartition en groupe de la première table d'entrelacement T en deux tables d'entrelacements T1 et T2 après les opérations d'entrelacement et de traitement (déplacement) des bits présents à des positions invalides, le cas échéant. Cette décomposition correspond avantageusement à la fin de l'entrelacement utile à la répartition des données à transmettre entre les deux média de communication RF et PLC utilisés selon l'exemple décrit.

La décomposition illustrée de la première table d'entrelacement T en deux tables d'entrelacementT1 et T2, au terme de l'entrelacement, constitue une orientation des données sous forme des bits de chacun des groupes de données donc de chacune des tables d'entrelacement T1 et T2 vers la couche MAC appropriée. Par ailleurs, pour une couche MAC donnée les bits sont également entrelacés.

Si le mode de réalisation décrit ci-avant illustre une transmission vers deux média différents (RF et PLC), le raisonnement est similaire pour ce qui concerne une répartition de données à transmettre vers trois, quatre ou plus encore de medium de communication. Ainsi la première table d'entrelacement T (la plus grande) comprend autant de tables d'entrelacement T1, T2, Ti que de média de communication distincts.

Bien évidemment, la représentation matricielle de T, T1, T2 et de T' a vocation à simplifier la compréhension de l'agencement des données pour les opérations d'entrelacement décrites, et chacune des tables pourrait être représentée sous forme d'un vecteur des bits, par exemple horizontal ou vertical comprenant des segments délimitant les lignes et les colonnes précédemment décrites.

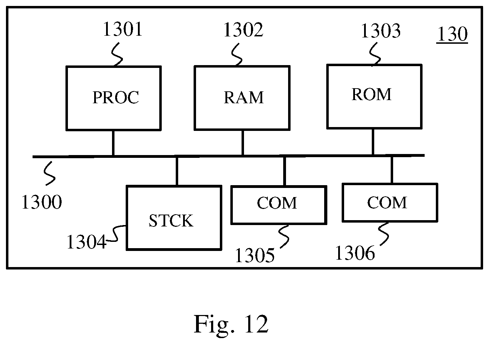

La Fig. 12 illustre schématiquement un exemple d'architecture matérielle d'un dispositif noeud 130 du réseau de communication maillé 120 selon un mode de réalisation. Un tel dispositif noeud 130 est par exemple un compteur ou un concentrateur de données.

Selon l'exemple d'architecture matérielle représenté à la Fig. 12, le dispositif noeud 130 comprend alors, reliés par un bus de communication 1300 : un processeur ou CPU (« Central Processing Unit » en anglais) 1301 ; une mémoire vive RAM (« Random Access Memory » en anglais) 1302; une mémoire morte ROM (« Read Only Memory » en anglais) 1303; une unité de stockage 1304 telle qu'un disque dur ou telle qu'un lecteur de support de stockage, e.g. un lecteur de cartes SD (« Secure Digital » en anglais); au moins une première interface de communication 1305 permettant au dispositif noeud 130 de communiquer avec les dispositifs noeuds appartenant à son voisinage réseau, e.g. les dispositifs noeuds 131 et 133 par courants porteurs en ligne et au moins une seconde interface de communication 1306 permettant au dispositif noeud 130 de communiquer avec les dispositifs noeuds appartenant à son voisinage réseau par radio-fréquences.

Le processeur 1301 est capable d'exécuter des instructions chargées dans la RAM 1302 à partir de la ROM 1303, d'une mémoire externe (non représentée), d'un support de stockage (tel qu'une carte SD), ou d'un réseau de communication. Lorsque le dispositif noeud est mis sous tension, le processeur 1301 est capable de lire de la RAM 1302 des instructions et de les exécuter. Ces instructions forment un programme d'ordinateur causant la mise en oeuvre, par le processeur 1301, de tout ou partie des procédés décrits en relation avec les Figs. 3 à 11.

Les procédés décrits en relation avec les Figs. 3 à 11 peuvent être implémentés sous forme logicielle par exécution d'un ensemble d'instructions par une machine programmable, par exemple un DSP (« Digital Signal Processor » en anglais) ou un microcontrôleur, ou être implémentés sous forme matérielle par une machine ou un composant dédié, par exemple un FPGA (« Field-Programmable Gate Array » en anglais) ou un ASIC (« Application-Specific Integrated Circuit » en anglais). En général, le dispositif noeud 130 comprend de la circuiterie électronique configurée pour mettre en oeuvre les procédés décrits en relation avec les Figs. 3 à 11.

## Revendications

1. Un procédé de transmission pour transmettre des données à partir d'un premier dispositif noeud vers un second dispositif noeud appartenant à un voisinage réseau dudit premier dispositif noeud, lesdits premier et second dispositifs noeuds appartenant à un réseau d'alimentation électrique et étant configurés pour transmettre lesdites données par courants porteurs en ligne et par radio-fréquences, **caractérisé en ce que** le procédé comprend les étapes suivantes mises en oeuvre par ledit premier dispositif noeud :
- répartir (S 12) les données en deux groupes de données par une opération d'entrelacement desdites données, chaque groupe étant associé à un medium de communication parmi les courants porteurs en ligne et les radio-fréquences, et
- transmettre (S14) chaque donnée à une couche MAC du médium de communication associé au groupe auquel appartient ladite donnée.

2. Le procédé selon la revendication 1, lequel comprend encoder les données par un encodeur Reed-Solomon et dans lequel répartir les données en deux groupes de données par une opération d'entrelacement desdites données s'applique aux données encodées.

3. Le procédé selon la revendication 1 ou 2, dans lequel répartir (S12) les données en deux groupes de données par une opération d'entrelacement desdites données comprend :
- générer un premier train binaire de N bits, chaque valeur binaire étant associée à un médium de communication parmi les courants porteurs en ligne et les radio-fréquences, N étant le nombre de données à transmettre à la couche MAC ;
- permuter, par inversion de bits, les bits dans le premier train binaire pour obtenir un second train binaire ;
et dans lequel transmettre (S14) chaque donnée à une couche MAC du médium de communication associé au groupe auquel appartient ladite donnée comprend :
- transmettre chaque donnée à la couche MAC du médium de communication associé à la valeur du bit correspondant à ladite donnée dans le second train de bits.

4. Le procédé selon la revendication 3, dans lequel générer un premier train binaire de N bits comprend :
a) initialiser des paramètres k, N_{RF} et N_{PLC} à 0 ;
b) Si D_{PLC}< D_{RF}, positionner un bit bₖ à une première valeur et incrémenter N_{RF} de 1, sinon positionner le bit bₖ à une seconde valeur et incrémenter N_{PLC} de 1, où D_{PLC} est un débit disponible pour le médium de communication courants porteurs en ligne et D_{RF} est un débit disponible pour le médium de communication radio-fréquences ;
c) Si N_{PLC}/(N_{PLC}+ N_{RF}) ≤ D_{PLC}/(D_{PLC}+ D_{RF}) positionner un bit bₖ₊₁ à ladite seconde valeur et incrémenter N_{PLC} de 1 sinon positionner le bit bₖ₊₁ à ladite première valeur et incrémenter N_{RF} de 1 ;
d) Si (k+1)<N-1, incrémenter k de 1 et reprendre à l'étape c).

5. Le procédé selon la revendication 1 ou 2, dans lequel répartir (S12) les données en deux groupes de données par une opération d'entrelacement desdites données comprend :
- obtenir deux tables d'entrelacement, chaque table d'entrelacement étant associée à un médium de communication ;
- transmettre chaque donnée à la couche MAC du médium de communication associé à la table d'entrelacement dans laquelle se trouve ladite donnée.

6. Procédé selon la revendication 5, dans lequel obtenir deux tables d'entrelacement, chaque table d'entrelacement étant associée à un médium de communication comprend :
- obtenir une première table d'entrelacement T *[m, n*] de bits représentatifs des données à transmettre, la première table d'entrelacement comprenant autant de secondes tables d'entrelacement Ti [*mᵢ*, *nᵢ*] de bits que de média de communication, chaque seconde table d'entrelacement Ti [*mᵢ*, *nᵢ*] étant attribuée à un seul desdits média de communication, des différences de dimensions entre des secondes tables d'entrelacement étant susceptibles de générer une ou plusieurs positions dites invalides comprises dans la première table d'entrelacement mais non comprises dans l'une au moins des secondes tables d'entrelacement,
- entrelacer les bits par décalages successifs des lignes *m* et des colonnes *n* de la première table T *[m, n*] d'entrelacement, les décalages successifs étant réalisés sous forme de permutations circulaires des bits respectivement par ligne et par colonne,
- déplacer tout bit détecté comme présent à une position invalide de la première table d'entrelacement vers une position d'une seconde table d'entrelacement qui est disponible après l'entrelacement des bits de la première table d'entrelacement, de sorte que chaque seconde table d'entrelacement comprenne des bits affectés à l'un desdits groupes de données.

7. Le procédé selon l'une quelconque des revendications 1 à 6, dans lequel dans le cas où une donnée est transmise par courants porteurs en ligne, ladite donnée est transmise sur au moins une bande fréquentielle appartenant à un ensemble de bandes fréquentielles comprenant :
- la bande fréquentielle CENELEC A;
- la bande fréquentielle CENELEC B; et
- la bande fréquentielle FCC ou la bande fréquentielle ARIB.

8. Le procédé selon l'une quelconque des revendications 1 à 7, dans lequel dans le cas où une donnée est transmise par radio-fréquences, ladite donnée est transmise sur une bande fréquentielle allant de 863 MHz à 870 MHz.

9. Un dispositif noeud appartenant à un réseau d'alimentation électrique, ledit dispositif noeud étant configuré pour transmettre des données par courants porteurs en ligne et par radio-fréquences à un autre noeud dudit réseau d'alimentation électrique appartenant à son voisinage réseau, le dispositif noeud étant **caractérisé en ce qu'**il comprend :
des moyens pour répartir les données en deux groupes de données par une opération d'entrelacement desdites données, chaque groupe étant associé à un medium de communication parmi les courants porteurs en ligne et les radio-fréquences, et
des moyens pour transmettre chaque donnée à une couche MAC du médium de communication associé au groupe auquel appartient ladite donnée.

10. Un produit programme d'ordinateur **caractérisé en ce qu'**il comprend des instructions pour mettre en oeuvre le procédé de transmission selon l'une quelconque des revendications 1 à 8, lorsque ledit programme est exécuté par un processeur.

11. Un support de stockage **caractérisé en ce qu'**il stocke un programme d'ordinateur comprenant des instructions pour mettre en oeuvre le procédé de transmission selon l'une quelconque des revendications 1 à 8, lorsque ledit programme est exécuté par un processeur.
